(19) **Europäisches Patentamt / European Patent Office / Office européen des brevets**

(11) **EP 1 895 736 B1**

(12) **EUROPEAN PATENT SPECIFICATION**

(45) Date of publication and mention
of the grant of the patent:
**10.08.2011 Bulletin 2011/32**

(51) Int Cl.:
*H04L 27/36* (2006.01)

(21) Application number: **07115285.4**

(22) Date of filing: **30.08.2007**

(54) **A method and a device for the detection and estimation of quadrature defects**

Verfahren und Vorrichtung zur Erkennung und Schätzung von Quadraturfehlern

Procédé et dispositif pour la détection et l'estimation de défauts de quadrature

(84) Designated Contracting States:
**AT DE GB IT**

(30) Priority: **30.08.2006 SE 0601794**

(43) Date of publication of application:
**05.03.2008 Bulletin 2008/10**

(73) Proprietor: **Nera networks**
**5020 Bergen (NO)**

(72) Inventors:
• **Lund, Sigurd Andre**
  **NO-5259, Hjellestad (NO)**
• **Vahlin, Anders**
  **NO-5222, Nesttun (NO)**

(74) Representative: **Bergquist, Kjell Gunnar**
**Albihns.Zacco**
**Torggatan 8**
**Box 142**
**401 22 Göteborg (SE)**

(56) References cited:
**EP-A- 1 120 944   EP-A- 1 511 264**

• **LANSCHUTZER C ET AL INSTITUTE OF ELECTRICAL AND ELECTRONICS ENGINEERS: "Integrated adaptive LO leakage cancellation for W-CDMA direct upconversion transmitters" IEEE RADIO FREQUENCY INTEGRATED CIRCUITS (RFIC) SYMPOSIUM, 8 June 2003 (2003-06-08), - 10 June 2003 (2003-06-10) pages 19-22, XP010646586 NEW YORK, US ISBN: 0-7803-7694-3**

**Description**

TECHNICAL FIELD

The present invention relates to a method for use in a circuit which uses a first and a second signal, I and Q, as inputs to a quadrature modulator. The method is intended to correct quadrature defects such as phase and amplitude defects between the I and Q signals. The invention also discloses a corresponding device.

BACKGROUND

Quadrature modulation is a well known technology within the field of, for example, telecommunications, and is a principle which makes use of two signals that have a phase difference of ninety degrees between them. Due to the phase difference of ninety degrees between the signals, the signals are often referred to as I and Q signals, "In-phase" and "Quadrature phase".

It is important that the phase difference between the signals is exactly ninety degrees, as even slight deviations from this can cause errors in the system which uses the modulated signal.

In addition to the phase difference, there is also a need for the amplitudes of the two signals to be equal.

Document WO 98/24209 discloses a method and a device for quadrature correction. According to the disclosure of that document, there is, inter alia, a need for a comparison with an ideal value, or alternatively, comparison is made with an average of other values. In the first case, i.e. comparison with an ideal value, there is a need for storing and maintaining a threshold which with high accuracy corresponds to an ideal value, and in the second case, there seems to be a need for a design with a rather high degree of complexity. A further method for detecting Quadrature Defects is described in EP 1 120 944 A2.

SUMMARY

As stated above, there is a need for a method by means of which quadrature defects between I and Q signals can be detected, as well as having the magnitude of the defects estimated. The method should also offer the ability to detect and estimate the magnitude of defects caused by LO leakage.

The method should be based on an algorithm with low complexity, while offering fast convergence, adaptive compensation, and should also be robust to interference and variations in operating conditions. Also, there should not be a need for storing exact values for comparison, or an overly complex design.

Such a method is offered by the present invention in that it discloses a method for use in a circuit which uses a first and a second signal, I and Q, as inputs to a quadrature modulator.

The method is intended to correct quadrature defects such as phase and amplitude defects in the quadrature modulator, and comprises sampling both the first and second signals I and Q before they are input to the quadrature modulator. The phrase "such as" should here be interpreted as meaning "inter alia", so that defects caused by circuits outside of the modulator can also be detected by means of the invention.

According to the invention, there is an evaluation of where in an I and Q coordinate system, a point defined by corresponding I and Q samples is positioned, and the detected level of the output of the quadrature modulator is compared to a predetermined threshold.

If the level exceeds the threshold, information about the location of the point defined by the I and Q samples is evaluated for use as input to a counter, and the output of the counter is used as input to a control loop for evaluating and correcting a quadrature defect, the magnitude of the defect being given by the value output by the counter.

The output level which is detected by means of the invention, as mentioned above, can be either the level of the signal envelope or, for example, the output power level over a period of time. If the output power level is used, there should be a suitable averaging function, so that the power level which is detected is neither an instantaneous level, nor an average which is formed over such a long period of time that the influence of the modulation can not be discerned.

Suitably, according to the method, use is made of a pulse shaping filter before the I and Q signals are input to the modulator, and the I and Q signals are sampled after the pulse shaping filter.

Thus, the invention addresses the needs mentioned above, and also offers another significant advantage: detection and correction of quadrature defects can be carried out during normal operation of a device, there is no need for "test modes" or the like.

BRIEF DESCRIPTION OF THE DRAWINGS

The invention will be described in more detail in the following, with reference to the appended drawings in which:

Fig 1 shows a rough block diagram of a circuit in which the invention is applied, and

Figs 2 - 6 show examples of quadrature imperfections to be corrected by means of the invention, and

Figs 7 - 12 show sectors for use in the invention.

DETAILED DESCRIPTION

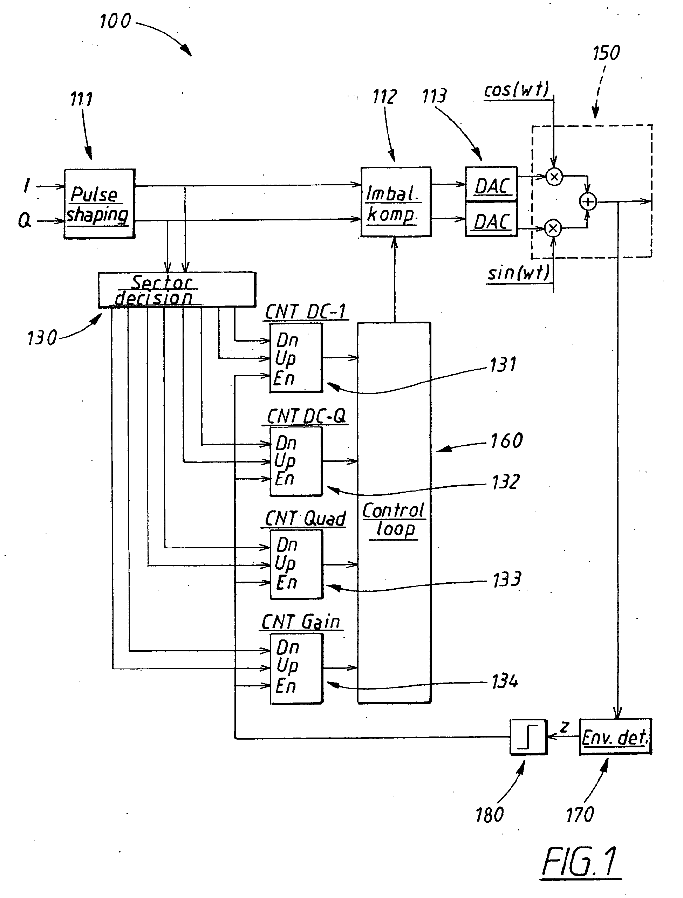

Fig 1 shows an example of a circuit 100 in which the invention may be used. The circuit 100 uses a first and a second digital signal, I and Q respectively, as inputs to a quadrature modulator 150. The quadrature modulator 150 in the circuit 100 is an analogue modulator, so the I and Q signals need to be processed by respective D/A-converters (DAC) 113 before being input to the modulator 150.

The circuit 100 also comprises a pulse shaping filter 111 to which the I and Q signals are input before the D/A-converters 113.

One of the purposes of the invention is to detect and estimate quadrature defects caused, inter alia, by the modulator. To this effect, the circuit 100 comprises means (not explicitly shown in fig 1) for sampling the I and Q signals, and inputting said corresponding I and Q samples to a means 130 for sector decision, which will be explained in detail later in this text.

Thus, time corresponding samples of the I and Q signals are input to the means 130 for sector decision. The inventors of the present invention have realized that it is advantageous to sample the I and Q signals at this stage, i.e. after the pulse shaping filter 111, as opposed to most other devices with the same purpose, i.e. correction of defects between I and Q. Said known device have usually sampled before such a filter.

Before the function of the sector decision means 130 and the use of its output is described in more detail, some background will be given regarding the quadrature defects which the invention is intended to correct.

There are three main quadrature defects or causes of quadrature defects that the invention addresses:

- LO leakage
- Quadrature defects
- Gain defects

The output of an ideal quadrature modulator can be seen as:

$$y = I \cdot \cos(\omega t) - Q \cdot \sin(\omega t) \qquad (1)$$

where I and Q are the in-phase and quadrature-phase components, respectively, of the signal to be transmitted. Including the undesired effects which it is intended to rectify by means of the invention, the distorted output of the modulator can be written as

$$y = (1 + \beta)(I + \delta_I) \cdot \cos(\omega t + \frac{\alpha}{2}) - (1 - \beta)(Q + \delta_Q) \cdot \sin(\omega t - \frac{\alpha}{2}) \qquad (2)$$

where $\alpha$ represents the quadrature defect, $\beta$ represents the gain defect and $\delta$ represents the LO leakage.

Below, some observations which have been made by the inventors of the present invention will now be discussed.

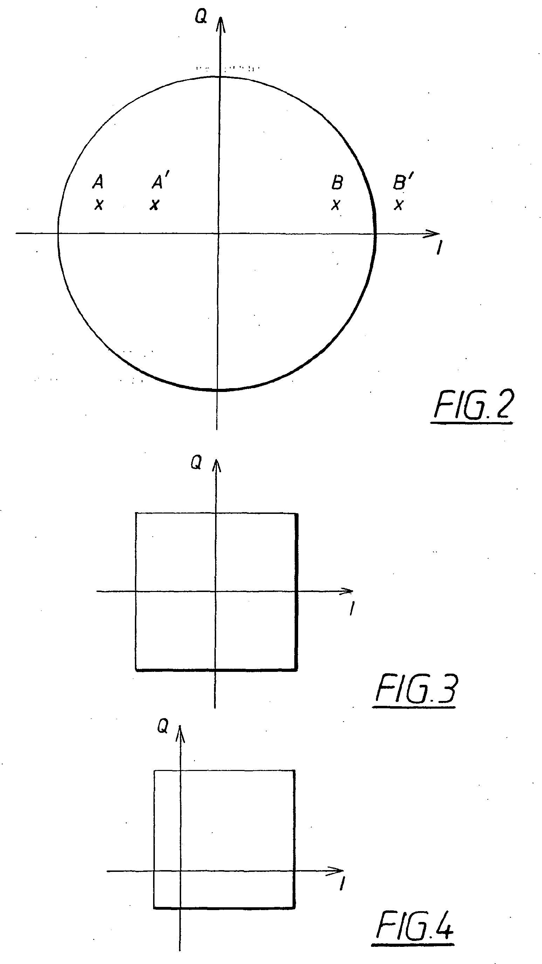

In the following, a principle of the invention will be illustrated with reference to figs 2-12. As has been mentioned previously, the invention can be applied either in a system where the level of the envelope of the output is measured, or where the output power level is measured and averaged over a period of time. Figs 2-12 are examples of a system in which the envelope is used, which is by way of explanation only, and should not be seen as restrictive to that application.

Fig 2 shows an I and Q coordinate system, the horizontal axis being the I axis, and the vertical axis being the Q axis. The envelope of the modulated signal which is output from the modulator 150 corresponds to the distance from the origin in the plane. If an envelope detector is used to detect the level of the output of the modulator, the radius of the circle shown in fig 2 can be seen as corresponding to the threshold mentioned previously, and used in the invention.

Corresponding samples of I and Q which are taken at the baseband level in fig 1 form unique points in the coordinate system shown in fig 2. Two different I/Q-pair samples A and B are shown in fig 2. The points formed by both of these sample pairs are inside the circle, and the "enable" signal will thus not be sent for either of them, meaning that these samples will not be used in the processing for correcting I and/or Q defects or imperfections.

In fig 2, alternative samples A' and B' are shown with a DC offset in the I direction, and the points in the coordinate system which correspond to this have been indicated as A' and B' respectively. As can be seen, A' is inside the threshold, while B' is not. Thus, B' will cause the enable signal, and these samples will be used in the processing, while the A' samples will not.

In order to illustrate how information about the location of the positions of the I and Q samples in the coordinate system can be used to detect the different quadrature defects, some examples will be shown in the following.

Fig 3 shows how points in the coordinate system formed by I and Q samples without any defects would look, while fig 4 shows the corresponding pattern for a system with a DC offset in both the I and Q signals. Naturally, a DC offset in only one of the signals would cause the pattern to be moved only in one direction, while the pattern shown in fig 4 is displaced in both the I and Q directions.

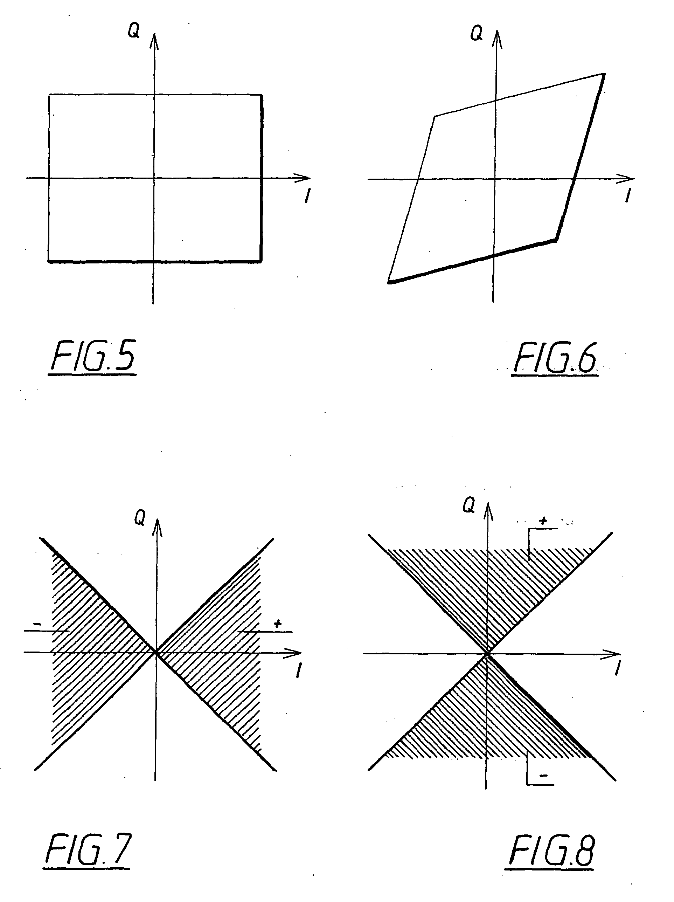

Fig 5 shows the points formed by corresponding I and Q signals in a system with a gain defect, the pattern being "compressed" in one direction, while fig 6 shows the points formed by corresponding I and Q signals in a system with a quadrature defect.

Returning now to the specific mechanisms utilized by the present invention, mechanisms which are similar to each other are used for detecting the existence and magnitude of the defects which the invention addresses. For that reason, said mechanism will be explained here, before the individual defects and their corresponding sectors are described.

As explained previously, the invention uses, inter alia, observations of the detected level of the modulated signal, and in more detail, as also explained previously, observations are made regarding the level with regard to a certain threshold.

By using this observation of the modulated signal, very simple and inexpensive circuits can be used, said circuits preferably but not necessarily being analogue. Observations from the modulated output which exceed a threshold are classified on the basis of samples of the digital input signals ("baseband signals") I and Q which were the corresponding input to the modulator for the samples of the level of the output.

The classification is done based on where corresponding I and Q samples are relative to each other in sectors or pairs of sectors in the coordinate system with I and Q as the axes of the system, meaning that each combination of corresponding I and Q samples will define a unique point in the I and Q coordinate system.

In order to detect quadrature imperfections and their magnitude, each sector or pair of sectors is linked to one of the defects which the invention is intended to correct and which have been shown above in figures 2-6, as will be explained in the following.

Each occurrence of a unique I/Q-point in a sector or pair of sectors which is linked to a certain defect is used as input to a counter which counts the number of points linked to that defect.

Thus, the output of the counter for a certain defect will indicate the existence and magnitude of the defect to which that counter is linked.

As indicated previously in this text, the circuit 100 comprises a sector decision means 130, i.e. a means for deciding in which sector of the coordinate system 1, the point defined by each I/Q-sample is located. This location is used to output the I/Q-sample to the proper counter, there being one counter for each defect which the circuit 100 is meant to be able to detect. It should be noted that sectors which are linked to different quadrature defects can overlap, so that one and the same I/Q-sample can cause an increase or decrease in more than one counter.

As shown in fig 1, the circuit 100 comprises four counters 131-134, since there are four kinds of defects which the circuit 100 can detect, these four kinds being:

- DC offset in the I direction, counter 131
- DC offset in the Q direction, counter 132
- Quadrature defects, counter 133
- Gain defects, counter 134

The use of the counters 131-134 is as follows: The circuit 100 comprises means 170 for detecting the level of the output of the modulator 150, and also comprises means 180 for comparing the level to a threshold value. The threshold value is set for each individual application, so that satisfactory results are achieved, but a rule of thumb which can be used is that 50% of the samples of the level of the output should exceed the threshold. This is naturally only an example, and many other percentages can be used, depending, for example, on the quality of the components used. The threshold can also be set by an automatic control loop to have a desired average percentage of samples exceeding the threshold.

The result of the comparison 180 is used as an "enable" signal for the counters 131-134, so that the counters will only be able to count inputs from the sector decision means 130 if the output of the modulator 150 exceeds the threshold.

Thus, if the level of the modulator output signal is below the threshold, the enable signal to the counters 131-134 is set to "0" or "Not enable", and conversely, if the amplitude exceeds the threshold value, the enable signal is set to "1" or "Enable".

The output of each counter 131-134 will indicate the existence of each kind of defect, and also the magnitude of that defect, and is used as input to a control loop 160, which in turn is connected to an imbalance compensator 112 which corrects the defects in the I and Q signals before they are input to the modulator 150.

The exact nature of the control loop 160 and the imbalance compensator 112 can be of many different kinds which are well known to those skilled in the field, and will for that reason not be explained in more detail here.

Below, the different sectors and their linkage to the different kinds of quadrature defects will be discussed.

**LO leakage**

One of the defects which it is intended to correct by means of the invention is LO leakage, which corresponds to a DC offset of at least one of the signals, I and/or Q. There can be a DC-offset either in the I or in the Q signal, or in both. Thus, the system needs to be able to detect both.

**DC-offset in the I-signal**

DC offset in the I-signal can be estimated using the I and Q coordinate system, along with the sectors shown in fig 7. As shown, the two sectors, which are used simultaneously, are the sectors defined by the following criteria: $I > |Q|$ and $I < -|Q|$.

The sectors in the coordinate system are used in the following manner: for level samples from the modulator 150 which exceed the threshold, an "enable" signal is sent to the counter 131, which counts the number of I and Q samples in the sectors shown in fig 7 and defined above.

The operation of the counter 131 is as follows:

- count **up** if the point defined by the I and Q sample is in the sector defined by

$$I > |Q|,$$

- count **down** if the point defined by the I and Q sample is in the sector defined by

$$I < -|Q|.$$

The operation caused by points located in the respective sectors in fig 7 has also been indicated by placing the operators "-" or "+" in the respective sector.

The output of the counter 131, a negative or positive integer, is used as input to the control circuit 160, which classifies the kind and magnitude of the quadrature defect that is linked to the output of the counter 131. This information is sent to the circuit 112 for defect compensation, which corrects the I and Q signals before they are input to the modulator 150.

**DC-offset in the Q-signal:**

As noted previously, there may be a DC-offset in the Q-signal as well. Thus, the counter 132 is used for counting occurrences of points defined by combinations of positions of I and Q samples which correspond to such an offset. The same principle as explained with reference to the counter 131 is also used for the counter 132, in other words for level samples from the modulator 150 which exceed the threshold, an "enable" signal is sent to a counter 132, which counts the number of I and Q samples in the sectors shown in fig 8.

The sectors in the I and Q coordinate system which correspond to a DC-offset in the Q-signal are thus those shown in fig 8:

- The "plus" sector is the sector defined by: $Q > |I|$,
- The "minus" sector is defined by: $Q < -|I|$.

For samples resulting in a level exceeding the threshold,

count **up** if the transmitted sample is in the sector defined by

$$Q > |I|,$$

count **down** if the transmitted sample is in the sector defined by

$$Q < -|I|.$$

The output of the counter 132 is used as input to the control circuit 160, which classifies the kind and magnitude of the quadrature defect that is linked to the output of the counter 132. This information is sent to the circuit 112 for defect compensation, which corrects the I and Q signals before they are input to the modulator 150.

## Quadrature defects

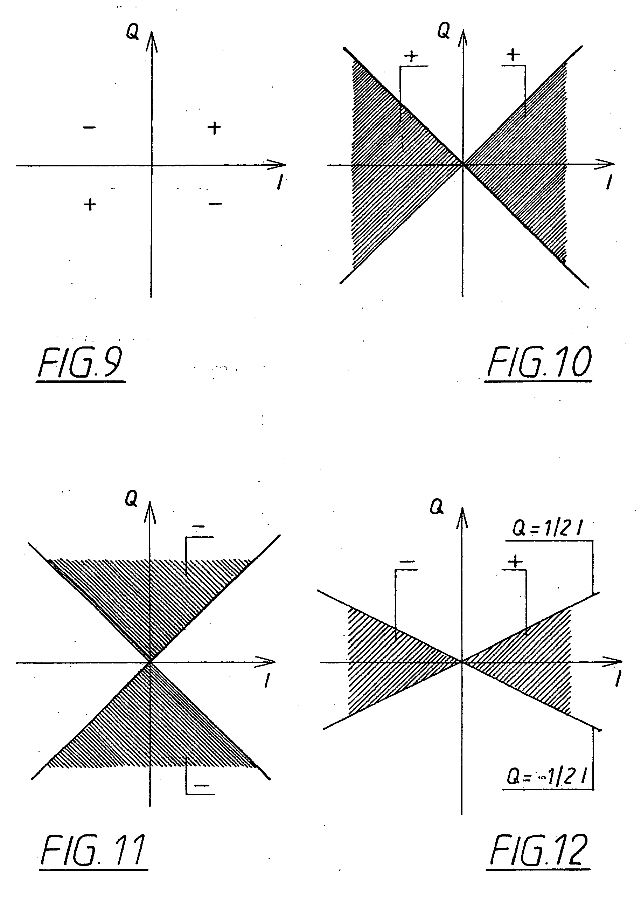

This kind of defect can be detected and estimated using a first and a second pair of sectors in the I and Q coordinate system, the sector pairs being diagonally opposed quadrants of the coordinate system, as shown in fig 9.
The same principle as previously is used, i.e. there is a counter 133 which is enabled if the level of the output from the modulator exceeds the threshold.
The sectors which are used for counting "up" when detecting quadrature defect are the first and third quadrants of the coordinate system, counting counter-clockwise, and the other two quadrants are used for counting down.

## Gain defects

This kind of defect can be detected and estimated using a first pair of sectors which are rotated 180 degrees with respect to each other, and a second pair of such sectors which pair is rotated 90 degrees with respect to the first pair. The first pair is shown in fig 10, and the second pair is shown in fig 11.
The sectors of figs 10 and 11 are defined and used as follows:

• count **up** if the transmitted sample is in one of the sectors defined by:

$$I > |Q| \text{ or } I < -|Q|$$

These two sectors are illustrated in fig 10.

• count **down** if the transmitted sample is in one of the sectors defined by:

$$Q > |I| \text{ or } Q < -|I|.$$

These two sectors are illustrated in fig 11.

The same principle as previously is used, i.e. the counter 134 is enabled if the level of the output from the modulator exceeds the threshold.
The invention is not limited to the examples of embodiments shown in the drawings and described above, the invention may be freely varied within the scope of the appended patent claims. For example, the number of counters shown in fig 1 and employed in the circuit 100 does not need to be four, but can be varied according to how many defects it is desired to correct for. For example, if it is only desired to correct for one defect, only one counter is needed.
In addition, if it is desired to detect and correct more than one defect, the different counters employed need not be different physical units, one and the same circuit with the desired function could be used.
As for the sectors used and their linkage to the different kinds of quadrature defects, it is perfectly feasible to use other sectors than those shown in figs 7-11. As an example intended to illustrate this, Fig 12 shows an alternative sector pair for use in the detection of DC offset in the I direction, the sectors in that figure being defined and used as follows.
• count **up** if the transmitted sample is in the sector defined by

$$I > 2|Q|,$$

• count **down** if the transmitted sample is in the sector defined by

$$I < -2|Q|.$$

Corresponding re-arrangements of the sectors are conceivable for the other defects.

**Claims**

1. A method for use in a circuit (100) which uses a first and a second signal, I and Q being an Inphase and Quadrature signal, respectively, as inputs to a quadrature modulator (150), the method being intended to detect and estimate the magnitude of at least one defect such as defects caused by LO leakage and/or defects such as phase and amplitude defects in the quadrature modulator, said method comprises:

   - sampling both the first and second signals I and Q before they are input to the quadrature modulator (150), and **characterized by**
   - evaluating (130) where in an I and Q coordinate system, a point defined by corresponding I and Q samples is positioned, said I and Q coordinate system being defined by a horizontal axis I and a vertical axis Q,
   - comparing (170, 180) the level of the output of the quadrature modulator (150) to a predetermined threshold,
   - if said level exceeds said threshold, information about the location of the point defined by the I and Q samples in said coordinate system is used as input to a counter (131-134),
   - using the output of said counter as input to a control loop for evaluating and correcting said defects in said quadrature modulator, wherein the value of said output of said counter is used to determine the magnitude of said defect.

2. The method of claim 1, according to which the level of the output of the modulator which is used is the level of the signal envelope of said output of said quadrature modulator.

3. The method of claim 1, according to which the level of the output of the modulator which is used is an average over a period of time of the power level of said output of said quadrature modulator.

4. The method of any of claims 1-3, according to which use is made of a pulse shaping filter (111) before the I and Q signals are input to the modulator (150), and according to which method the I and Q signals are sampled after said pulse shaping filter (111).

5. The method of any of claims 1-4, according to which the evaluation (130) of the point defined by corresponding I and Q samples comprises linking points in a first pair of sectors in the coordinate system to a first quadrature defect, said sectors being defined by regions defined in said coordinate system by said I and Q axes..

6. The method of any of claims 1 - 4, according to which the evaluation (130) of the point defined by corresponding I and Q samples comprises linking points in a second pair of sectors in the coordinate system to a second quadrature defect, said sectors being defined by regions defined in said coordinate system by said I and Q axes..

7. The method of any of claims 1-6, according to which the evaluation (130) of the point defined by corresponding I and Q samples comprises linking points in a third pair of sectors in the coordinate system to a third quadrature defect, said sectors being defined by regions defined in said coordinate system by said I and Q axes.

8. The method of any of claims 1-7, according to which the evaluation (130) of the point defined by corresponding I and Q samples comprises linking points in a fourth pair of sectors in the coordinate system to a fourth quadrature defect, said sectors being defined by regions defined in said coordinate system by said I and Q axes.

9. The method of any of claims 1-8, applied to a system (100) in which the I and Q signals are digital, are and input to a digital to analogue converter (113 before being input to the quadrature modulator (150) being implemented as an analogue quadrature modulator.

10. A circuit (100) which uses a first and a second signal, I and Q, as inputs to a quadrature modulator (150), the circuit (100) comprising means for detecting and estimating the magnitude of defects caused by LO leakage and quadrature defects in said quadrature modulator, such as phase and amplitude defects, said means comprising:

   - means for sampling both the first and second signals I and Q before they are input to the quadrature modulator (150),

   and **characterized by**:

   - means (130) for evaluating where in an I and Q coordinate system that a point defined by corresponding I and Q samples is positioned,
   - means (170, 180) for comparing the level of the output of the quadrature modulator (150) to a predetermined threshold,
   - counting means (131-134) to which information about the location of the point defined by the I and Q samples in said coordinate system is used as input, if said level exceeds said threshold,
   - a control loop (160) to which the output of the counter (131-134) is

   input and used for evaluating and correcting a quadrature defect, the magnitude of said defect being determined by the value output by the counter (131-134).

11. The circuit of claim 10, in which the level of the output of the quadrature modulator (150) which is used is the level of the signal envelope of said output of said quadrature modulator.

12. The circuit of claim 10, in which the level of the output of the modulator which is used is an average over a period of time of the power level of said output of said quadrature modulator.

13. The circuit (100) of any of claims claim 10-12, further comprising a pulse shaping filter (111) to which I and Q signals are input, and the output of which is used as input to the modulator (150), and in which circuit (100) the I and Q signals are sampled after said pulse shaping filter (111).

14. The circuit (100) of any of claims 10-13, in which the means (130) for evaluating the point defined by corresponding I and Q samples links points in a first pair of sectors in the coordinate system to a first quadrature defect, said sectors being defined by regions defined in said.

15. The circuit (100) of any of claims 10-14, in which the evaluation means (130) links points in a second pair of sectors in the coordinate system to a second quadrature defect, said sectors being defined by regions defined in said.

16. The circuit (100) of any of claims 10-15, in the evaluation means (130) of the point defined by corresponding I and Q samples links points in a third pair of sectors in the coordinate system to a third quadrature defect, said sectors being defined by regions defined in said coordinate system by said I and Q axes.

17. The circuit (100) of any of claims 10-16, in which the evaluation means (130) of the point defined by corresponding I and Q links points in a fourth pair of sectors in the coordinate system to a fourth quadrature defect, said sectors being defined by regions defined in said coordinate system by said I and Q axes.

18. The system (100) of any of claims 10-17, in which the I and Q signals are digital, and are input to a digital to analogue converter (113 before being input to the quadrature modulator (150) being implemented as an analogue quadrature modulator.

**Patentansprüche**

1. Verfahren zur Verwendung in einer Schaltung (100), die ein erstes und ein zweites Signal, I und Q, die ein Inphasen- bzw. ein Quadratursignal sind, als Eingangsgrößen für einen Quadraturmodulator (150) verwendet, wobei das Verfahren dazu vorgesehen ist, die Größe wenigstens eines Fehlers zu bestimmen und zu schätzen, wie zum Beispiel durch LO-Verlust verursachte Fehler und/oder Phasen- und Amplitudenfehler in dem Quadraturmodulator, wobei das Verfahren umfasst:

   - Abfragen sowohl des ersten als auch des zweiten Signals I und Q bevor diese in den Quadraturmodulator (150) eingegeben werden, und **gekennzeichnet durch**
   - Berechnen (130), wo in einem I und Q Koordinatensystem ein Punkt, der **durch** Vergleichen der I und Q Abfragen definiert wird, positioniert ist, wobei das I und Q Koordinatensystem **durch** eine horizontale Achse I und eine vertikale Achse Q definiert ist,
   - Vergleichen (170, 180) des Pegels der Ausgangsgrößen des Quadraturmodulators (150) mit einem vorbestimmten Schwellwert,
   - wenn der Pegel den Schwellwert übersteigt, wird Information über die Position des **durch** die I und Q Abfragen definierten Punktes in dem Koordinatensystem als Eingangsgröße für einen Zähler (131-134) verwendet,
   - Verwenden der Ausgangsgröße des Zählers als Eingangsgröße für eine Steuerschleife zum Berechnen und Korrigieren der Fehler in dem Quadraturmodulator, wobei der Wert der Ausgangsgröße des Zählers dazu verwendet wird, die Größe des Fehlers zu bestimmen.

2. Verfahren des Anspruchs 1, nach dem der Pegel der Ausgangsgröße des verwendeten Modulators der Pegel der Signal-Einhüllenden der Ausgangsgröße des Quadraturmodulators ist.

3. Verfahren des Anspruchs 1, nach dem der Pegel der Ausgangsgröße des verwendeten Modulators ein Mittelwert über eine Zeitperiode des Leistungspegels der Ausgangsgröße des Quadraturmodulators ist.

4. Verfahren nach einem der Ansprüche 1-3, nach dem ein Pulsformungs-Filter (111) verwendet wird bevor die I und Q Signale in dem Modulator (150) eingegeben werden, und nach dem Verfahren werden die I und Q Signale nach dem Pulsformungs-Filter (111) abgefragt.

5. Verfahren nach einem der Ansprüche 1-4, nach dem die Berechnung (130) des durch die I und Q Abfragen definierten Punktes umfasst Verbinden von Punkten in einem ersten Paar von Abschnitten in dem Koordinatensystem mit einem ersten Quadraturfehler, wobei die Abschnitte durch Gebiete definiert werden, die in dem Koordinatensystem durch die I und Q Achsen definiert werden.

6. Verfahren nach einem der Ansprüche 1-4, nach dem die Berechnung (130) des durch die I und Q Abfragen definierten Punktes umfasst Verbinden von Punkten in einem zweiten Paar von Abschnitten in dem Koordinatensystem mit einem zweiten Quadraturfehler, wobei die Abschnitte durch Gebiete definiert werden, die in dem Koordinatensystem durch die I und Q Achsen definiert werden.

7. Verfahren nach einem der Ansprüche 1-6, nach dem die Berechnung (130) des durch die I und Q Abfragen definierten Punktes umfasst Verbinden von Punkten in einem dritten Paar von Abschnitten in dem Koordinatensystem mit einem dritten Quadraturfehler, wobei die Abschnitte durch Gebiete definiert werden, die in dem Koordinatensystem durch die I und Q Achsen definiert werden.

8. Verfahren nach einem der Ansprüche 1-7, nach dem die Berechnung (130) des durch die I und Q Abfragen definierten Punktes umfasst Verbinden von Punkten in einem vierten Paar von Abschnitten in dem Koordinatensystem mit einem vierten Quadraturfehler, wobei die Abschnitte durch Gebiete definiert werden, die in dem Koordinatensystem durch die I und Q Achsen definiert werden.

9. Verfahren nach einem der Ansprüche 1-7 angewendet auf ein System (100), in dem die I und Q Signale digital sind und in einen digital-nach-analog Wandler (113) eingegeben werden bevor diese in den Quadraturmodulator (150) eingegeben werden, der als ein analoger Quadraturmodulator implementiert ist.

10. Schaltung (100), die ein erstes und ein zweites Signal, I und Q, als Eingangsgrößen für einen Quadraturmodulator (150) verwendet, wobei die Schaltung Mittel zum Bestimmen und Schätzen der Größe Fehlern, die von LO-Verlust und Quadraturfehlern in dem Quadraturmodulator verursacht werden, wie zum Beispiel Phasen- und Amplitudenfehler, umfasst, wobei die Mittel umfassen:

- Mittel zum Abfragen sowohl des ersten als auch des zweiten Signals I und Q bevor diese in den Quadraturmodulator (150) eingegeben werden, und **gekennzeichnet durch**:
- Mittel (130) zum Berechnen, wo in einem I und Q Koordinatensystem ein Punkt, der **durch** Vergleichen von I und Q Abfragen definiert wird, positioniert ist,
- Mittel (170, 180) zum Vergleichen des Pegels der Ausgangsgrößen des Quadraturmodulators (150) mit einem vorbestimmten Schwellwert,
- Zählmittel(131-134), für das Information über die Position des **durch** die I und Q Abfragen definierten Punktes in dem Koordinatensystem als Einganggröße für einen Zähler verwendet wird, wenn der Pegel den Schwellwert übersteigt,
- eine Steuerschleife (160), an die die Ausgangsgröße des Zählers (131-134) eingegeben wird und die zum Berechnen und Korrigieren eines Quadraturfehlers verwendet wird, wobei die Größe des Fehlers **durch** den Wert der Ausgangsgröße des Zählers (121-134) bestimmt wird.

11. Schaltung (100) nach Anspruch 10, in der der Pegel der Ausgangsgröße des verwendeten Quadraturmodulators (150) der Pegel der Signal-Einhüllenden der Ausgangsgröße des Quadraturmodulators ist.

12. Schaltung (100) nach Anspruch 10, in der der Pegel der Ausgangsgröße des verwendeten Modulators ein Mittelwert des Leistungspegels der Ausgangsgröße des Quadraturmodulators über eine Zeitperiode ist.

13. Schaltung (100) nach einem der Ansprüche 10-12, weiterhin einen Pulsformungs-Filter (111) umfasst, in den die I und Q Signale eingegeben werden und dessen Ausgangsgröße als Eingangsgröße für den Modulator verwendet wird, und in der Schaltung (100) werden die I und Q Signale nach dem Pulsformungs-Filter (111) abgefragt.

14. Schaltung (100) nach einem der Ansprüche 10-13, in der das Mittel (130) zum Berechnen des Punktes, der durch Vergleichen von I und Q Abfragen definiert wird, Punkte in einem ersten Paar von Abschnitten in dem Koordinatensystem mit einem ersten Quadraturfehler verbindet, wobei die Abschnitte durch Gebiete definiert werden, die in dem Koordinatensystem durch die I und Q Achsen definiert werden.

15. Schaltung (100) nach einem der Ansprüche 10-14, in der das Berechnungs-Mittel (130) Punkte in einem zweiten Paar von Abschnitten in dem Koordinatensystem mit einem zweiten Quadraturfehler verbindet, wobei die Abschnitte durch Gebiete definiert werden, die in dem Koordinatensystem durch die I und Q Achsen definiert werden.

16. Schaltung (100) nach einem der Ansprüche 10-15, in der das Berechnungs-Mittel (130) des Punktes, der durch Vergleichen von I und Q Abfragen definiert wird, Punkte in einem dritten Paar von Abschnitten in dem Koordinatensystem mit einem dritten Quadraturfehler verbindet, wobei die Abschnitte durch Gebiete definiert werden, die in dem Koordinatensystem durch die I und Q Achsen definiert werden.

17. Schaltung (100) nach einem der Ansprüche 10-16, in der das Berechnungs-Mittel (130) des Punktes, der durch Vergleichen von I und Q definiert wird, Punkte in einem vierten Paar von Abschnitten in dem Koordinatensystem mit einem vierten Quadraturfehler verbindet, wobei die Abschnitte durch Gebiete definiert werden, die in dem Koordinatensystem durch die I und Q Achsen definiert werden.

18. System (100) nach einem der Ansprüche 10-17, in dem die I und Q Signale digital sind und in einen digital-nach-analog Wandler (113) eingegeben werden bevor diese in den Quadraturmodulator (150) eingegeben werden, der als ein analoger Quadraturmodulator implementiert ist.

## Revendications

1. Procédé destiné à être utilisé dans un circuit (100) utilisant comme entrées dans un modulateur en quadrature (150) un premier et un second signal, 1 et Q, qui sont respectivement un signal en phase et en quadrature, le procédé étant destiné à détecter et à estimer l'amplitude d'au moins un défaut tel que les défauts provoqués par une fuite de l'OL et/ou des défauts tels que des défauts de phase et d'amplitude dans le modulateur en quadrature, ledit procédé comprenant :

l'échantillonnage à la fois du premier et du second signal I et Q avant de les appliquer à l'entrée du modulateur en quadrature (150),
et **caractérisé par**
l'évaluation (130) de l'emplacement où est positionné dans un système de coordonnées I et Q un point défini par des échantillons I et Q correspondants, ledit système de coordonnées I et Q étant défini par un axe horizontal I et un axe vertical Q,
la comparaison (170, 180) à un seuil prédéterminé du niveau de la sortie du modulateur en quadrature (150), si ledit niveau dépasse ledit seuil, on utilise comme entrée d'un compteur (131 à 134) des informations concernant l'emplacement du point défini par les échantillons I et Q,
l'utilisation de la sortie dudit compteur comme entrée d'une boucle de contrôle pour évaluer et corriger lesdits défauts dans ledit modulateur en quadrature, dans lequel la valeur de ladite sortie dudit compteur est utilisée pour déterminer l'amplitude dudit défaut.

2. Procédé selon la revendication 1, selon lequel le niveau de la sortie du modulateur utilisée est le niveau de l'enveloppe de signal de ladite sortie dudit modulateur en quadrature.

3. Procédé selon la revendication 1, selon lequel le niveau de la sortie du modulateur utilisée est la moyenne pendant une certaine période de temps du niveau de puissance de ladite sortie dudit modulateur en quadrature.

4. Procédé selon l'une quelconque des revendications 1 3, selon lequel on utilise un filtre de conformation d'impulsions (111) avant que les signaux I et Q soient appliqués à l'entrée du modulateur (150), et procédé selon lequel les signaux I et Q sont échantillonnés après ledit filtre de conformation d'impulsion (111).

5. Procédé selon l'une quelconque des revendications 1 à 4, selon lequel l'évaluation (130) du point défini par les échantillons I et Q correspondants comprend la liaison à un premier défaut de quadrature de points dans une première paire de secteurs dans le système de coordonnées, lesdits secteurs étant définis par des régions définies dans ledit système de coordonnées par lesdits axes I et Q.

6. Procédé selon l'une quelconque des revendications 1 à 4, selon lequel l'évaluation (130) du point défini par les échantillons I et Q correspondants comprend la liaison à un deuxième défaut de quadrature de points dans une deuxième paire de secteurs dans le système de coordonnées, lesdits secteurs étant définis par des régions définies dans ledit système de coordonnées par lesdits axes I et Q.

7. Procédé selon l'une quelconque des revendications 1 à 6, selon lequel l'évaluation (130) du point défini par les échantillons I et Q correspondants comprend la liaison à un troisième défaut de quadrature de points dans une troisième paire de secteurs dans le système de coordonnées, lesdits secteurs étant définis par des régions définies dans ledit système de coordonnées par lesdits axes I et Q.

8. Procédé selon l'une quelconque des revendications 1 à 7, selon lequel l'évaluation (130) du point défini par les échantillons I et Q correspondants comprend la liaison à un quatrième défaut de quadrature de points dans une quatrième paire de secteurs dans le système de coordonnées, lesdits secteurs étant définis par des régions définies dans ledit système de coordonnées par lesdits axes I et Q.

9. Procédé selon l'une quelconque des revendications 1 à 8, appliqué à un système (100) dans lequel les signaux I et Q sont numériques, et sont appliqués à l'entrée d'un convertisseur numérique-analogique (113) avant d'être appliqués à l'entrée du modulateur en quadrature (150), mis en oeuvre sous forme d'un modulateur analogique en quadrature.

10. Circuit (100) utilisant un premier et un second signal, I et Q comme entrées dans un modulateur en quadrature (150) le circuit (100) comprenant un moyen pour détecter et estimer l'amplitude de défauts provoqués par une fuite de l'OL et de défauts de quadrature dans ledit modulateur en quadrature, tels que des défauts de phase et d'amplitude, ledit moyen comprenant :

un moyen pour échantillonner à la fois les premier et second signaux I et Q avant de les appliquer à l'entrée du modulateur en quadrature (150),
et **caractérisé par**
un moyen (130) pour évaluer l'emplacement où est positionné dans un système de coordonnées I et Q, un point défini par des échantillons I et Q correspondants,
un moyen (170, 180) pour comparer à un seuil prédéterminé le niveau de la sortie du modulateur en quadrature (150),

un moyen de comptage (131 à 134) dans lequel sont utilisés comme entrées des informations concernant l'emplacement du point défini par les échantillons I et Q dans ledit système de coordonnées, si ledit niveau dépasse ledit seuil,

une boucle de contrôle (160) à l'entrée de laquelle est appliquée la sortie du compteur (131 à 134) et qui est utilisée pour évaluer et corriger un défaut de quadrature, l'amplitude dudit défaut étant déterminée par la valeur de sortie du compteur (131 à 134).

**11.** Circuit selon la revendication 10, dans lequel le niveau de la sortie du modulateur en quadrature (150) qui est utilisé est le niveau de l'enveloppe de signal de ladite sortie dudit modulateur en quadrature.

**12.** Circuit selon la revendication 10, dans lequel le niveau de la sortie du modulateur utilisé est une moyenne pendant une certaine période de temps du niveau de puissance de ladite sortie dudit modulateur en quadrature.

**13.** Circuit (100) selon l'une quelconque des revendications 10 à 12, comprenant en outre un filtre de conformation d'impulsions (111) à l'entrée de laquelle sont appliqués les signaux ou I et Q, et dont la sortie est utilisée comme entrée du modulateur (150), circuit (100) dans lequel les signaux I et Q sont échantillonnés après ledit filtre de conformation d'impulsions (111).

**14.** Circuit (100) selon l'une quelconque des revendications 10 à 13, dans lequel le moyen (130) pour évaluer le point défini par les échantillons I et Q correspondants relie à un premier défaut de quadrature des points d'une première paire de secteurs dans le système de coordonnées, lesdits secteurs étant définis par les régions définies dans ledit système de coordonnées par lesdits axes I et Q.

**15.** Circuit (100) selon l'une quelconque des revendications 10 à 14, dans lequel le moyen d'évaluation (130) relie à un deuxième défaut de quadrature des points d'une deuxième paire de secteurs dans le système de coordonnées, lesdits secteurs étant définis par les régions définies dans ledit système de coordonnées par lesdits axes I et Q.

**16.** Circuit (100) selon l'une quelconque des revendications 10 à 15, dans lequel le moyen d'évaluation (130) du point défini par les échantillons I et Q correspondants relie à un troisième défaut de quadrature des points d'une troisième paire de secteurs dans le système de coordonnées, lesdits secteurs étant définis par les régions définies dans ledit système de coordonnées par lesdits axes I et Q.

**17.** Circuit (100) selon l'une quelconque des revendications 10 à 16, dans lequel le moyen d'évaluation (130) du point défini par les échantillons I et Q correspondants relie à un quatrième défaut de quadrature des points d'une quatrième paire de secteurs dans le système de coordonnées, lesdits secteurs étant définis par les régions définies dans ledit système de coordonnées par lesdits axes I et Q.

**18.** Système (100) selon l'une quelconque des revendications 10 à 17, dans lequel les signaux I et Q sont numériques et sont appliqués à l'entrée d'un convertisseur numérique-analogique (113) avant d'être appliqués à l'entrée du modulateur en quadrature (150) qui est mis en oeuvre sous forme d'un modulateur analogique en quadrature.

FIG.1

_FIG.2_

_FIG.3_

_FIG.4_

FIG.5

FIG.6

FIG.7

FIG.8

FIG.9

FIG.10

FIG.11

FIG.12

**EP 1 895 736 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9824209 A

- EP 1120944 A2